# DEMANDE DE BREVET EUROPEEN

(11) **EP 0 966 076 A1**
(43) Date de publication de la demande: **22.12.1999**
(21) Numéro de dépôt: 99401447.0
(22) Date de dépôt: 14.06.1999
(51) Int. Cl.: H01S 3/025, H01S 3/103, G02B 6/122, H01L 27/15, H01L 33/00

(54) **Composant monolithique électro-optique multi-sections**

(30) Priorité: 15.06.1998 FR 9807492
(71) Demandeur: ALCATEL, 75008 Paris (FR)
(72) Inventeur: Mallecot, Franck, 92120 Montrouge (FR); Plais, Antonina, 75019 Paris (FR); Chaumont, Christine, 94800 Villejuif (FR)
(74) Mandataire: Fournier, Michel Robert Marie

(57) **Abrégé**

L'invention se rapporte à un composant monolithique électro-optique multi-sections en semi-conducteur. Ce composant comprend au moins deux sections (20, 30, 40) ayant chacune respectivement un premier et un deuxième guides d'onde (21, 31) qui sont gravés sous forme de rubans, disposés en ligne et enterrés dans une couche de gaine. Les sections sont électriquement isolées les unes des autres par une zone résistive. Ce composant est particulièrement caractérisé en ce que, à l'interface entre deux sections, les guides d'ondes présentent localement une largeur étendue (l₂₁, l₃₁) au moins égale à la largeur (l_{I}) de la zone résistive.

## Description

La présente invention se rapporte à un composant monolithique électro-optique en semi-conducteur comprenant au moins deux sections, disposées en ligne, ayant chacune un guide d'onde gravé sous la forme d'un ruban et enterré dans une couche de gaine.

Pour ce type de composant électro-optique multi-sections à ruban enterré, il est important d'avoir une isolation électrique élevée entre chaque section. Typiquement, il est nécessaire d'avoir une résistance au moins égale à 15kΩ à l'interface entre deux sections, afin d'éviter des interactions entre celles-ci au cours du fonctionnement du composant.

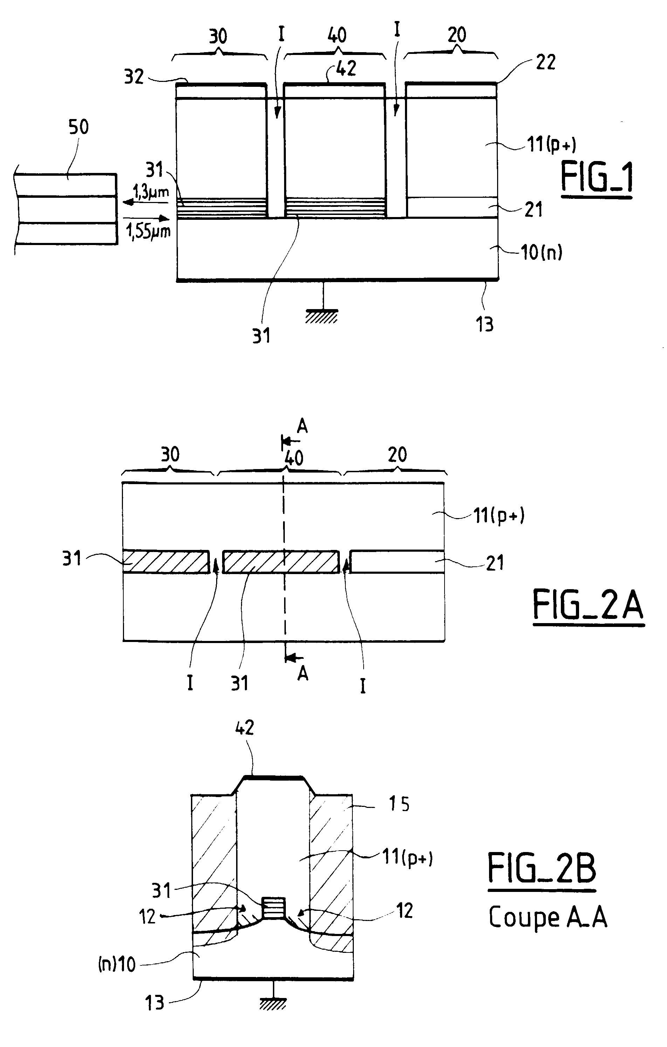

A titre d'exemple, la figure 1 représente un schéma en coupe longitudinale d'un composant émetteur-récepteur en ligne, noté 1D-TRD ("In-line Transmitter Receiver Device" en littérature anglo-saxonne), obtenu par intégration monolithique d'un laser 30 et d'un détecteur 20 sur un même substrat 10. Le laser 30 émet un signal, par exemple à une longueur d'onde de 1,3 µm vers une fibre optique 50, tandis que le détecteur reçoit un signal, en provenance de cette même fibre optique 50, par exemple à une longueur d'onde de 1,55 µm. Dans cet exemple, étant donné que la longueur d'onde d'émission est inférieure à la longueur d'onde de réception, le composant comporte une troisième section, disposée entre le laser 30 et le détecteur 20, formant un isolant optique 40. Le rôle de cet isolant optique 40 consiste à absorber la lumière émise, à 1,3 µm, par la face arrière du laser et à éviter ainsi un éblouissement du détecteur, de manière à ce que celui-ci puisse détecter le signal optique à 1,55 µm en provenance de la fibre optique. Le substrat 10 peut par exemple être de l'InP dopé n. Les guides d'onde respectivement 21 du détecteur 20 et 31 du laser 30 et de l'isolant optique 40 sont gravés sous forme de rubans et enterrés dans une couche de gaine 11 fortement dopée. Les guides d'onde sont dits de type BRS ("Buried Ridge Structure" en littérature anglo-saxonne). Le matériau de gaine est par exemple dopé p+, lorsque le substrat est dopé n. Ce matériau étant fortement dopé, il est rendu conducteur.

La figure 2A représente une vue de dessus du composant de la figure 1 et la figure 2B représente une vue en coupe latérale selon A-A. Sur cette figure 2B, des canaux conducteurs, situés de part et d'autre du guide 31, sont référencés 12. La présence de ces canaux conducteurs est due au fait que la couche de gaine 11 est fortement dopée. Une implantation latérale en protons ou une gravure latérale, référencée 15 sur le schéma de la figure 2B, rendant le matériau résistif, permet par ailleurs de limiter la largeur de ces canaux conducteurs 12 à une valeur comprise typiquement entre 10 et 12µm, et de réaliser une isolation latérale du composant. Les canaux conducteurs 12 empêchent cependant l'obtention d'une résistance très élevée à l'interface entre deux sections.

La composition et les dimensions des guides d'onde importent peu. Dans l'exemple de la figure 1, le guide d'onde 21 du détecteur 20 est par exemple réalisé en matériau ternaire, alors que le guide d'onde 31 du laser 30 et de l'isolant optique 40 est réalisé dans une structure à puits quantiques.

D'autre part, des électrodes métalliques 22, 32, 42, 13 sont formées sur les différentes sections et sur la face inférieure du composant, de manière à permettre son fonctionnement.

Du fait de la présence des canaux conducteurs 12 de part et d'autre des rubans de guide d'onde, il est nécessaire de réaliser des zones d'isolation électrique I, ou zones résistives, entre les différentes sections 20, 30, 40 afin d'éviter toute perturbation d'une section vis à vis d'une autre lors du fonctionnement du composant.

Pour réaliser ces zones résistives I, et obtenir une résistance d'interface très élevée entre deux sections consécutives, trois solutions ont été étudiées jusqu'à présent.

La première solution consiste à faire croître, par épitaxie, un matériau de phosphure d'indium semi-isolant (InP : Fe) aux interfaces entre les sections. Cependant cette solution ne peut pas encore être adaptée à une production industrielle. De plus, elle requiert une étape supplémentaire de croissance, ce qui n'est pas envisageable pour la réalisation d'un composant à bas coût.

La deuxième solution consiste à graver le matériau de gaine 11 dans les zones I situées aux interfaces entre les sections.

La troisième solution consiste à faire une implantation de protons dans le matériau de gaine 11, localement dans les zones I situées aux interfaces entre les sections. Dans ce cas, les protons créent des défauts cristallins qui permettent d'inverser le type de population. Ainsi, le matériau de gaine 11 est rendu localement semi-isolant et donc hautement résistif.

Cependant, ces deux dernières solutions présentent un inconvénient majeur. En effet, pour obtenir une isolation électrique suffisante, c'est à dire pour obtenir une résistance d'interface supérieure ou égale à 15kΩ, il apparaît nécessaire de réaliser soit la gravure, soit l'implantation de protons, sur une grande profondeur et notamment de traverser les guides d'onde (voir figure 1). Or, le fait de graver un guide d'onde, ou d'implanter des protons dans le coeur d'un guide d'onde, implique l'apparition de défauts cristallins dans le matériau. Ces défauts cristallins engendrent la création de centres de diffusion de la lumière, ce qui entraîne des pertes optiques aux interfaces entre les sections. Le fonctionnement du composant est donc dégradé par les pertes optiques. De plus, ces pertes sont d'autant plus élevées que le nombre d'interfaces à traverser augmente. Ainsi, le signal lumineux, à 1,55 µm, qui est issu de la fibre optique 50 et injecté vers le détecteur 20, doit traverser consécutivement deux interfaces. Les pertes optiques sont par conséquent très élevées.

A titre d'exemple, pour un signal reçu, à une longueur d'onde de 1,55 µm, les pertes optiques, dues à une implantation protonique d'une densité de 2.10¹⁴ cm⁻², sont de l'ordre de 0,8 dB pour une distance implantée de 5 µm de long, ce qui correspond à des pertes de l'ordre de 3 dB pour un composant ayant deux sections implantées de 10 µm de long.

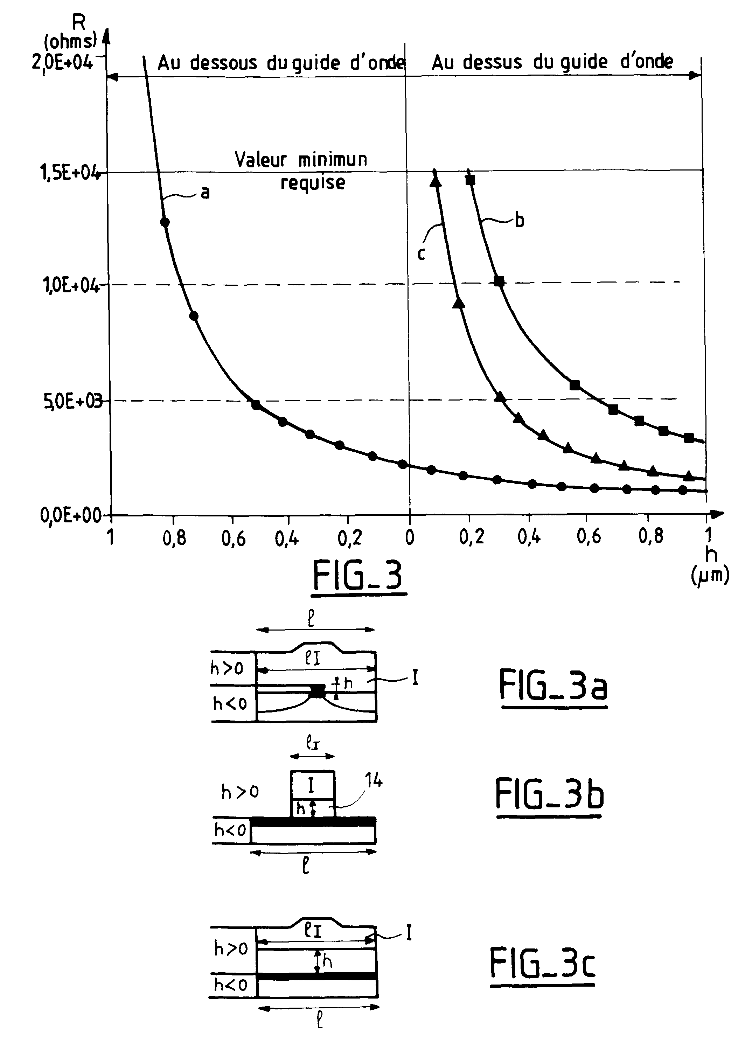

D'autre part, la courbe a de la figure 3, représente la valeur de la résistance d'interface R en fonction de la distance h entre le fond de la zone d'implantation (ou de gravure) I et la surface supérieure du guide d'onde, pour un composant, représenté en coupe dans le sens de la largeur sur la figure 3a, similaire au composant à ruban actif enterré de la figure 1. Cette courbe a démontre que pour atteindre une résistance supérieure ou égale à 15 kΩ, il faut implanter des protons à travers le guide d'onde (ou graver), de telle sorte que le fond de la zone résistive I soit situé à une distance h de l'ordre de 0,8 à 0,9 µm au dessous de la surface supérieure des guides d'onde.

La courbe b de cette figure 3 représente quant à elle la valeur de la résistance d'interface R en fonction de la distance h entre le fond de la zone d'implantation (ou de gravure) et la surface supérieure du guide d'onde, pour un composant de l'art antérieur dans lequel le guide d'onde est dit de type "ridge", c'est à dire qu'il n'est pas gravé. Ce composant, représenté en coupe dans le sens de la largeur sur la figure 3b, comporte une couche supérieure 14, déposée sur le guide d'onde, qui est gravée sur une largeur et sur une longueur déterminées pour créer un contraste d'indice et permettre d'assurer le guidage de la lumière. Dans ce composant, les guides d'onde ne sont pas enterrés. Des valeurs satisfaisantes de résistances d'interfaces R sont obtenues pour des profondeurs d'implantation (ou de gravure) de la couche supérieure 14 suffisamment faible, c'est à dire pour des profondeurs telles que le fond de la zone résistive I se situe à une distance h comprise entre 0,2 et 0,1 µm au-dessus de la surface supérieure du guide d'onde. Par conséquent dans ce cas, le guide d'onde n'est pas dégradé par l'implantation (ou la gravure).

Un but de la présente invention consiste donc à réaliser un composant monolithique électro-optique multi-sections, à ruban actif enterré (guide d'onde de type BRS), dans lequel des zones d'isolation électrique hautement résistives I sont réalisées, aux interfaces entre les sections, sur une profondeur suffisamment faible pour ne pas atteindre le guide d'onde. Ce composant devra par ailleurs présenter des résistances d'interface R du même ordre de grandeur que celles obtenues avec le composant comportant un ruban de type "ridge".

L'invention a plus particulièrement pour objet un composant monolithique électro-optique en semi-conducteur comprenant au moins deux sections ayant chacune respectivement un premier et un deuxième guides d'onde, lesdits guides d'onde étant gravés sous forme de ruban, disposés en ligne et enterrés dans une couche de gaine, et lesdites sections étant électriquement isolées les unes des autres par une zone résistive, caractérisé en ce que à l'interface entre deux sections, les guides d'onde présentent localement une largeur étendue au moins égale à la largeur de la zone résistive.

Les rubans de guides d'onde des différentes sections du composant, présentent donc une zone localement étendue permettant de supprimer localement les canaux conducteurs situés de part et d'autre des guides d'onde, et par conséquent d'augmenter la résistance d'interface.

Selon une autre caractéristique de l'invention, la zone résistive présente une largeur au moins égale à la largeur conductrice de la couche de gaine. La largeur conductrice de la couche de gaine est définie comme étant la somme des largeurs des canaux conducteurs et du guide d'onde enterré dans cette gaine. Une telle largeur de la zone résistive permet de supprimer localement les canaux conducteurs latéraux et contribue à l'obtention d'une isolation électrique suffisante entre deux sections, c'est à dire une résistance au moins égale à 15 kΩ.

Selon une autre caractéristique de l'invention, la zone résistive est obtenue par implantation locale de protons dans la couche de gaine, et présente un fond situé à une distance au moins égale à 0.08 µm au-dessus de la surface supérieure des guides d'ondes.

Selon une autre caractéristique, la zone résistive est obtenue par gravure locale de la couche de gaine, et présente un fond situé à une distance au moins égale à 0.08 µm au-dessus de la surface supérieure des guides d'ondes.

Grâce à cette structure de composant multi-sections, les résistances obtenues aux interfaces entre les sections sont très élevées. Elles sont typiquement supérieures ou égales à 15 kΩ. Ces valeurs sont obtenues sans que la zone d'isolation électrique atteigne le guide d'onde si bien que les pertes optiques aux interfaces entre les sections sont considérablement réduites et le fonctionnement du composant électro-optique n'est pas perturbé.

D'autres particularités et avantages de l'invention apparaîtront à la lecture de la description donnée à titre d'exemple illustratif et non limitatif et faite en référence aux figures annexées qui représentent :
- la figure 1, déjà décrite , un schéma en coupe longitudinale d'un composant émetteur-récepteur en ligne selon l'art antérieur,
- les figures 2A et 2B, déjà décrites, respectivement une vue de dessus et une vue en coupe latérale du composant de la figure 1,
- la figure 3, des courbes a, b, c indiquant la valeur de la résistance d'interface R en fonction de la distance h entre le fond de la zone résistive (I) et la surface supérieure des guides d'onde, ces courbes étant associées respectivement à deux composants de l'art antérieur, représentés sur les figures 3a et 3b, et à un composant selon l'invention représenté sur la figure 3c,
- les figures 4A et 4B, respectivement deux vues en coupe longitudinale de deux types de composants émetteur-récepteur en ligne selon l'invention,
- les figures 5A, 5B et 5C, respectivement une vue de dessus, une vue en coupe latérale dans la zone d'isolation électrique et une vue en coupe latérale dans l'une des sections du composant de la figure 4A,
- les figures 6A et 6B, respectivement une vue de dessus et une vue en coupe latérale du composant de la figure 4A selon une variante de réalisation.

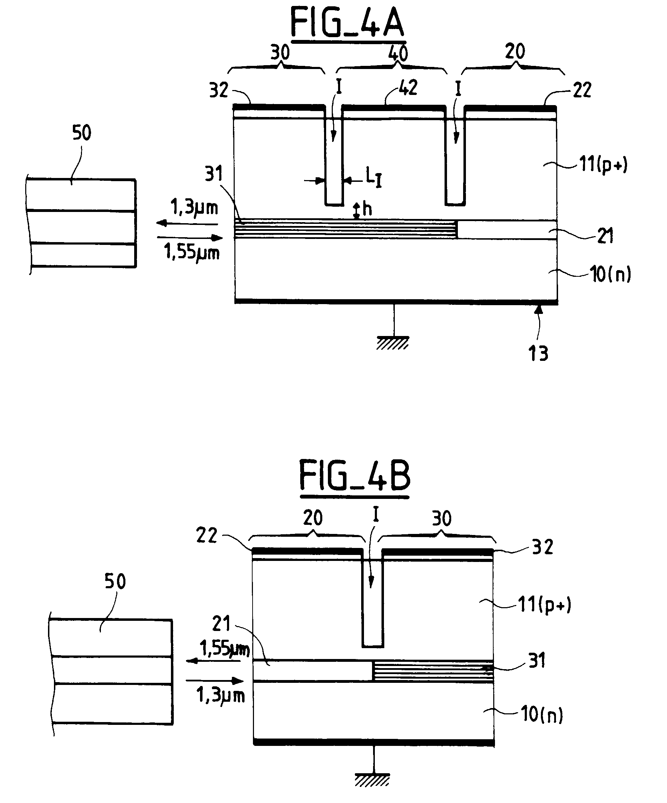

Les figures 4A et 4B représentent deux types de composant émetteur-récepteur en ligne selon l'invention, vus en coupe longitudinale. Le composant représenté sur la figure 4A correspond au composant de la figure 1 et les mêmes références sont utilisées pour désigner les mêmes éléments. La seule différence visible par rapport au composant de l'art antérieur, tel que schématisé sur la figure 1, réside dans le fait que les zones d'isolation électrique I sont réalisées sur une profondeur suffisamment faible pour ne pas atteindre les guides d'ondes 21 et 31 et les garder intacts.

Le composant représenté sur la figure 4B comporte seulement deux sections. En effet, dans ce cas, le laser 30 émet à une longueur d'onde de 1,55 µm qui est supérieure à la longueur d'onde de 1,3 µm de réception du détecteur 20. Le détecteur 20 reste donc transparent à la longueur d'onde de 1,55 µm, et il reçoit correctement le signal qui lui est envoyé à 1,3 µm, si bien qu'il n'est pas nécessaire de placer une section absorbante optiquement entre le laser et le détecteur.

Dans ce cas aussi, la zone résistive I, située à l'interface entre les deux sections, est réalisée de telle sorte qu'elle ne traverse pas les guides d'ondes 21, 31.

Les exemples qui sont décrits ci-après se rapportent au composant émetteur-récepteur en ligne de la figure 4A. Mais l'invention ne se limite pas à ce type de composant. Elle s'applique en effet à tous les composants électro-optiques multi-sections comportant des rubans de guides d'onde enterrés dans une couche de gaine. Ainsi elle peut encore par exemple s'appliquer à des lasers multi-sections utilisés pour effectuer des accords en longueurs d'onde etc...

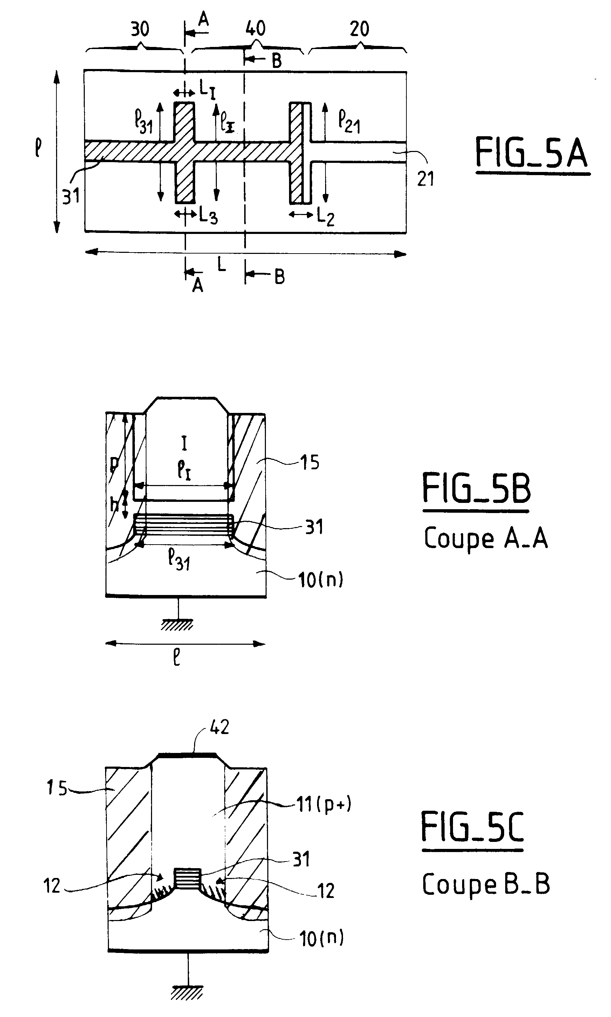

La structure d'un tel composant multi-sections selon l'invention sera mieux comprise au regard des figures 5A, 5B et 5C qui représentent le composant de la figure 4A respectivement en vue de dessus et en coupes latérales.

La largeur l_{I} de la zone résistive I est définie le long de la largeur 1 du composant, et la longueur L_{I} de la zone résistive I est définie le long de la longueur L du composant.

La vue de dessus de la figure 5A indique que les guides d'onde 21 et 31 des différentes sections détecteur 20, laser 30 et isolant optique 40 sont gravés sous forme de rubans, mais qu'en revanche ils présentent une largeur plus importante aux interfaces entre les sections. En fait, les rubans de guides d'onde 21 et 31 présentent localement une largeur respectivement l₂₁ et l₃₁ au moins égale à la largeur l_{I} de la zone résistive I. Le fait d'augmenter la largeur des rubans de guides d'onde sur toute la largeur de la zone résistive I, permet de supprimer localement les canaux conducteurs qui sont créés de part et d'autre du ruban et qui sont dus au fort dopage de la couche de gaine 11.

De plus les guides d'ondes sont localement élargis, à l'interface entre deux sections, sur une longueur globale L₂, L₃ de préférence au moins égale à la longueur L_{I} de la zone résistive I. La longueur globale est définie comme étant la somme des longueurs des portions élargies des différents guides. Ainsi, par exemple, à l'interface entre les sections isolant optique 40 et détecteur 20, la longueur globale L₂ de la zone élargie correspond à la longueur de la portion élargie du guide d'onde 31 ajoutée à la longueur de la portion élargie de l'autre guide d'onde 21.

La vue en coupe latérale selon A-A sur la figure 5B représente le guide d'onde 31, situé à l'interface, entre les deux sections laser 30 et isolant optique 40.

Le ruban de guide d'onde 31 présente à cette interface, une largeur étendue l₃₁ égale à la largeur l_{I} de la zone résistive I. Le fait de prolonger ainsi la largeur du guide d'onde 31 permet de supprimer localement les canaux conducteurs 12 situés de part et d'autre du guide d'onde et tels que représentés sur la figure 5C, qui schématise une vue en coupe, selon B-B, de la section isolant optique 40. La largeur de ces canaux conducteurs 12 est d'autre part délimitée par une zone résistive 15 obtenue préalablement, par implantation de protons ou par gravure, pour isoler latéralement le guide d'onde 31.

Pour obtenir une bonne isolation électrique à l'interface entre les sections 30 et 40, la largeur de la zone résistive l_{I} est donc de préférence au moins égale à la largeur conductrice de la couche de gaine 11, c'est à dire à la somme des largeurs du guide d'onde 31 (l₃₁) et des canaux conducteurs 12. La largeur l_{I} de la zone résistive est donc délimitée par les zones d'isolation latérales 15.

La zone d'isolation électrique I est par ailleurs formée sur une profondeur p suffisamment faible pour ne pas traverser ni même atteindre le guide d'onde 31. Ainsi, la zone résistive I présente un fond situé à une certaine distance h au-dessus de la surface supérieure du guide d'onde 31.

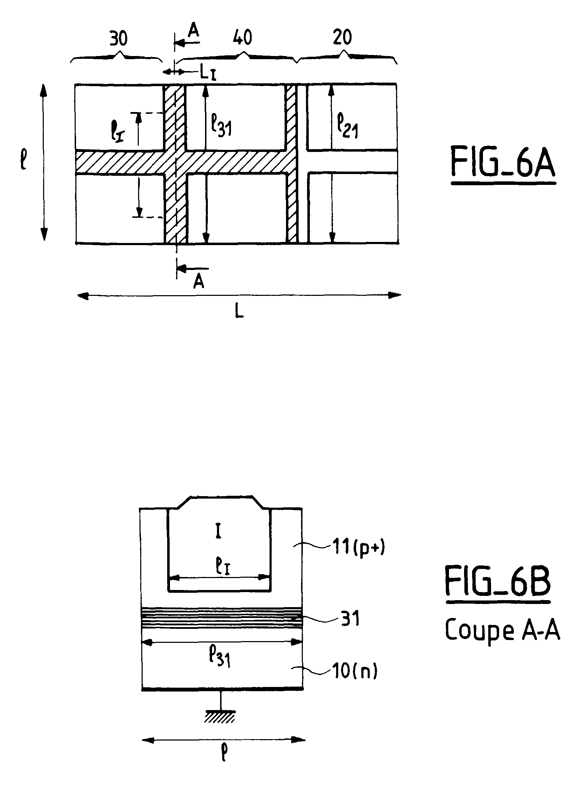

Dans une variante de réalisation, telle que schématisée sur les figures 6A et 6B, on peut faire en sorte que le guide d'onde, situé au dessous de la zone d'isolation I soit localement non gravé, de manière à ce qu'il présente une largeur l₃₁, l₂₁ égale à celle 1 du composant optique.

La zone d'isolation électrique I peut indépendamment être obtenue par implantation de protons ou alors par gravure du matériau de gaine. Du fait que l'implantation, ou la gravure, ne traverse pas les guides d'ondes, les pertes optiques aux interfaces entre les sections de l'émetteur-récepteur en ligne selon l'invention sont considérablement réduites.

La figure 3 représente trois courbes comparatives de la valeur de la résistance d'interface R en fonction de la distance h entre le fond de la zone résistive I et la surface supérieure du guide d'onde. Les courbes a et b ont été décrites ci-dessus et correspondent à deux composants multi-sections de l'art antérieur.

Le niveau 0 de la distance h correspond à la surface supérieure du guide d'onde.

La courbe c représente les valeurs de résistance d'interface R obtenues avec un composant selon l'invention, représenté en coupe sur la figure 3c, dont les rubans de guides d'onde sont enterrés dans une couche de gaine. Les valeurs de résistance se rapprochent de celles du composant antérieur à ruban de type "ridge". En fait, on obtient des résistances d'interface R supérieures ou égales à 15kΩ pour des distances h, entre le fond de la zone résistive I et la surface supérieure du ruban de guide d'onde au moins égales à 0,08 µm.

Ces résultats sont très satisfaisants puisqu'ils correspondent aux valeurs de résistances souhaitées. De plus, dans ce cas le guide d'onde n'est pas atteint et n'est donc pas dégradé. Les pertes optiques, situées aux interfaces entre les sections et dues à une implantation (ou une gravure) dans le coeur du guide, sont par conséquent évitées.

Le décalage entre les courbes b et c, correspondant respectivement au composant antérieur à ruban "ridge" et au composant selon l'invention, est simplement dû au fait que dans le composant à ruban "ridge" la zone résistive présente une largeur l_{I} de 3 µm environ, alors que la largeur l_{I} de la zone d'isolation I du composant selon l'invention est légèrement plus élevée, par exemple de l'ordre de 10 µm.

L'invention ne s'applique pas seulement à l'émetteur-récepteur en ligne qui vient d'être décrit. En fait, elle s'applique, de manière plus générale, à tous les composants électro-optiques monolithiques multi-sections comprenant un ruban actif enterré. Elle est par ailleurs indépendante de la composition et des dimensions des guides d'onde, ainsi que du type de dopage, n ou p , du substrat et de la couche de gaine.

## Revendications

1. Composant monolithique électro-optique en semi-conducteur comprenant au moins deux sections (20, 30, 40) ayant chacune respectivement un premier et un deuxième guides d'onde (21, 31), lesdits guides d'onde étant gravés sous forme de rubans, disposés en ligne et enterrés dans une couche de gaine (11), et lesdites sections étant électriquement isolées les unes des autres par une zone résistive (I), caractérisé en ce que, à l'interface entre deux sections, les guides d'ondes présentent localement une largeur étendue (l₂₁, l₃₁) au moins égale à la largeur (l_{I}) de la zone résistive (I).

2. Composant selon la revendication 1, caractérisé en ce que les guides d'ondes (21, 31) sont localement élargis, à l'interface entre deux sections, sur une longueur globale (L₂, L₃) au moins égale à la longueur (L_{I}) de la zone résistive (I).

3. Composant selon la revendication 1 ou 2, caractérisé en ce que la zone résistive (I) présente une largeur (l_{I}) au moins égale à la largeur conductrice de la couche de gaine (11).

4. Composant selon l'une des revendications 1 à 3, caractérisé en ce que la zone résistive (I) est obtenue par implantation locale de protons dans la couche de gaine (11), et présente un fond situé à une distance (h) au moins égale à 0,08 µm au dessus de la surface supérieure des guides d'ondes (21, 31).

5. Composant selon l'une des revendications 1 à 3, caractérisé en ce que la zone résistive (I) est obtenue par gravure locale de la couche de gaine (11) et présente un fond situé à une distance (h) au moins égale à 0,08 µm au dessus de la surface supérieure des guides d'ondes (21, 31).

6. Composant selon l'une des revendications 1 à 5 caractérisé en ce qu'il constitue un émetteur-récepteur en ligne.
